(19) Europäisches Patentamt
European Patent Office
Office européen des brevets

(11) **EP 3 282 493 B1**

(12) **EUROPÄISCHE PATENTSCHRIFT**

(45) Veröffentlichungstag und Bekanntmachung des Hinweises auf die Patenterteilung:
**11.03.2020 Patentblatt 2020/11**

(51) Int Cl.:
***H01L 39/24*** (2006.01)     ***H01B 12/06*** (2006.01)

(21) Anmeldenummer: **16183537.6**

(22) Anmeldetag: **10.08.2016**

(54) **HOCHTEMPERATUR-SUPRALEITER-BANDLEITER MIT EDELSTAHL-SUBSTRAT**

HIGH TEMPERATURE SUPERCONDUCTOR TAPE HAVING STAINLESS STEEL SUBSTRATE

RUBAN SUPRACONDUCTEUR HAUTE TEMPERATURE COMPRENANT UN SUBSTRAT EN ACIER INOXYDABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**14.02.2018 Patentblatt 2018/07**

(73) Patentinhaber: **Theva Dünnschichttechnik GmbH 85737 Ismaning (DE)**

(72) Erfinder: **KOENEN, Timo 81925 München (DE)**

(74) Vertreter: **Wegner, Hans**
**Bardehle Pagenberg Partnerschaft mbB**
**Patentanwälte, Rechtsanwälte**
**Prinzregentenplatz 7**
**81675 München (DE)**

(56) Entgegenhaltungen:
**EP-A1- 1 143 532**     **EP-A2- 0 441 724**
**EP-A2- 2 506 324**     **JP-A- 2011 113 662**
**US-A1- 2012 021 917**

## Beschreibung

### 1. Technisches Gebiet

Die vorliegende Erfindung betrifft einen Hochtemperatur-Supraleiter-Bandleiter (HTS-Bandleiter) mit einem Substrat, das Edelstahl umfasst.

### 2. Technischer Hintergrund

Die vorliegende Erfindung bezieht sich auf die Herstellung kristallin orientierter Schichten, insbesondere von Hochtemperatur-Supraleitern, auf technischen Substraten, um einen Hochtemperatur-Supraleiter-Bandleiter zu erhalten. Unter technischen Substraten sind solche Unterlagen zu verstehen, die im Vergleich zu einkristallinen Unterlagen billig herzustellen sind und nach einer Einglättung beschichtet werden können. Solche technischen Substrate umfassen insbesondere Metallbleche, -folien und -bänder. Aktuell werden solche HTS-Bandleiter u. a. auf verhältnismäßig teuren Nickelbasislegierungen aufgebracht.

Dünne bi-axial orientierte Schichten finden in der Technik breite Anwendung. Ein typisches Beispiel sind Dünnschichten aus Hochtemperatur-Supraleitern (HTS), die sowohl für Anwendungen in der Hochfrequenz- als auch in der Energietechnik eingesetzt werden können. Das Verschwinden des elektrischen Widerstandes unterhalb der Sprungtemperatur $T_c$ ermöglicht dabei geringere Leitungsverluste und die Erhöhung des Wirkungsgrades verschiedenster Vorrichtungen zur Speicherung, Umwandlung, Transport oder zur Erzeugung von elektrischer Energie. Um eine hohe Stromtragfähigkeit der HTS - Schicht > 1 MA/cm$^2$ zu gewährleisten, müssen in diesen Materialien Großwinkelkorngrenzen weitestgehend vermieden werden. Optimale Ergebnisse lassen sich deshalb nur mit nahezu einkristallinen, bi-axial texturierten Schichten erreichen.

Da es sich bei den HTS-Schichten selbst um Keramiken handelt und diese daher nicht wie z.B. Kupfer zu Drähten aus Extrudern gezogen und dann gewickelt werden können, scheidet man HTS-Schichten durch gängige Verfahren der physikalischen (PVD) oder chemischen (CVD oder MOD) Beschichtungstechnik auf flexiblen metallischen Bändern ab.

Ein solcher HTS - Bandleiter oder im Folgenden auch kurz "Bandleiter" genannt, kann in etablierten Anwendungen Kupferdraht ersetzen und dort vielfach höhere elektrische Ströme transportieren. Diese hohen Ströme würden im Kupfer zu hohen ohmschen Verlusten oder gar zum Versagen des Leiters führen. Mit dem Einsatz von Supraleitern können diese Verluste verringert werden.

Zudem können auch Komponenten, bei denen bereits heute metallische Tieftemperatur-Supraleiter statt Kupferleiter eingesetzt werden, z.B. Magnetresonanztomographen oder starke Elektromagnete, verbessert werden. Die HTS erlauben eine deutlich höhere Betriebstemperatur und halten höheren Magnetfeldern stand. Die daraus resultierende Verringerung des Kühlaufwandes führt zu einem einfacheren Aufbau und einer Verbesserung des Wirkungsgrades.

Neben dem hier angeführten Beispiel der HTS gibt es jedoch noch eine Vielzahl weiterer Materialien mit besonderen elektronischen Eigenschaften wie Ferroelektrizität, photovoltaischen oder thermoelektrischen Effekten und Magnetismus, die bevorzugt in bi-axial texturierter Form in der Sensorik eingesetzt werden. Auch in diesen Fällen benötigt man kostengünstige Substrate mit geeigneten Oberflächeneigenschaften, die die Herstellung dünner orientierter Schichten dieser Materialien erlauben.

Üblicherweise benötigt man zur Abscheidung orientierter, epitaktischer Schichten einkristalline Substrate, die die Anordnung der Atome in der Schicht und damit deren kristalline Orientierung vorgeben. Da solche Substrate sehr teuer sind und nicht in beliebiger Größe zur Verfügung stehen, ist es vorteilhaft, billige technische Substrate wie polykristalline Keramiken oder Metallbleche, -folien oder -bänder als Unterlagen zu verwenden. Um die dort fehlende, kristallographische Orientierung herzustellen, wurden spezielle Beschichtungsverfahren zur Erzeugung bi-axial orientierter Pufferschichten entwickelt, die als Epitaxieunterlage dienen können. Ein etabliertes Verfahren ist die "ion beam assisted deposition" (IBAD), bei der während der Deposition ein unterstützender Ionenstrahl unter einem bestimmten Winkel auf die Substratoberfläche gerichtet wird. Basisvarianten dieses Verfahrens werden beschrieben in der EP 0 872 579 und EP 1 178 129. Bei einem anderen gängigen Verfahren, der "inclined substrate deposition" (ISD) erfolgt die Beschichtung aus der Gasphase unter einem Winkel auf ein gekipptes Substrat. Bei hohen Beschichtungsraten und geeigneter Wahl der Depositionsparameter lassen sich auch dadurch orientierte Schichten abscheiden. Dieses Verfahren wurde in EP 0 669 411 und EP 0 909 340 detailliert beschrieben. Schichten dieser Art werden im folgenden MgO-ISD genannt. Insgesamt folgt die Herstellung von supraleitenden Bandleitern den folgenden Schritten:

a) Substratreinigung

b) Optional: mechanisches Schleifen längs der Bandrichtung zur Konditionierung der Oberfläche - vorzugsweise mit Diamantbürsten (entsprechend einem Schleifpapier mit normgemäßer Körnung 2000 und feiner)

c) Substratglättung durch Abtrag der Oberfläche mittels Elektropolitur oder mechanischer Politur, oder Aufbringen einer oder mehrerer Glättungsschichten

d) Erzeugung mindestens einer bi-axial texturierten Pufferschicht, durch gängige Verfahren wie ISD oder Ionen-Unterstützung

e) Abscheidung mindestens einer HTS-Schicht mit einer Dicke von mindestens 500 nm

f) Abscheidung einer dünnen Kontaktschicht aus einem Edelmetall wie Silber mit einer Dicke von mindestens 100 nm, bevorzugt mehr als 500 nm.

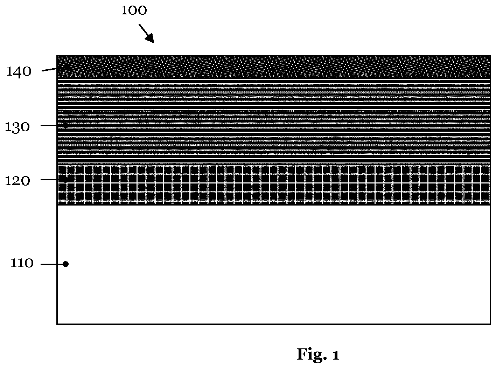

Abbildung 1 zeigt im Querschnitt den resultierenden grundlegenden Aufbau des HTSBandleiters.

Um die Kosten eines HTS-Bandleiters gering zu halten, ist es von großem Interesse eine möglichst kostengünstige Substratlegierung zu verwenden. Dabei gibt es neben der elektrochemischen Polierbarkeit und hohen Festigkeit weitere verschiedene Anforderungen an die Legierungen. So erzeugen magnetische Metallbänder im Wechselstrombetrieb des HTS-Bandleiters zusätzliche, unerwünschte Hystereseverluste. Amagnetische Legierungen wie Hastelloy C276 oder auch Nickel-Wolfram-Legierungen mit hohem Wolframanteil werden daher bevorzugt eingesetzt, sind jedoch aufgrund des hohen Legierungsanteils von Refraktärmetallen (Mo, W) teuer. Auch im Bereich der Edelstähle gibt es bereits Sorten, die Verwendung als Substrat finden, wie z.B. in EP 1143 532 beschrieben. Die darin beschriebenen Edelstähle sind aufgrund ihrer Zusammensetzung jedoch auch noch teuer und zum Teil schwer als Folienmaterial zu beschaffen.

JP 2011-113662 A, US 2012/021917 A1 und EP 0 441 724 A2 offenbaren HTS-Bandleiter mit Substraten aus austenitischen Edelstählen mit 16 bis 18 Massenprozent Chrom-Anteil (SUS 316L, SUS 316 LN, SUS 301). Für die HTS-Bandleiter von EP 1 143 532 A1 und EP 2 506 324 A2 wurden austenitische Edelstahlsubstrate mit 24 bis 26 Massenprozent Cr (SUS 314, SUS 310S) einer elektrochemischen Politur, beispielsweise mit einem Schwefelsäure-Phosphorsäure-Elektrolyten, unterzogen.

Der vorliegenden Erfindung liegt deshalb die Aufgabe zugrunde, einen Hochtemperatur-Supraleiter-Bandleiter (HTS-Bandleiter) mit einem sehr kostengünstigen, und möglichst gut verfügbaren Standard- Edelstahl-Substrat bereitzustellen, welches zugleich trotzdem für hohe Stromdichten geeignet ist.

## 3. Zusammenfassung der Erfindung

Diese Aufgabe wird durch einen HTS-Bandleiter gelöst, der ein austenitisches Edelstahl-Substrat mit einem Chrom-Anteil von weniger als 18 Massenprozent und einer Oberflächengüte gemäß Anspruch 1 aufweist.

Der geringe Chrom-Anteil von weniger als 18 Massenprozent führt einerseits zu einer deutlichen Reduzierung der Anschaffungskosten für das Substrat-Material und ermöglicht andererseits die Verwendung hoher Stromdichten im Bereich von beispielsweise 1 MA/cm$^2$ und darüber. Die umfangreichen Studien und Messreihen der Anmelderin zeigen, dass auch bei einem geringeren Chrom-Anteil eine hohe Stromdichte des Hochtemperatur-Supraleiter-Substrats erreicht werden kann. Teure Speziallegierungen wie zum Beispiel Hastelloy oder Edelstähle mit hohem Chromanteil werden daher nicht mehr benötigt. Die Anmelderin hat herausgefunden, dass ein beanspruchter Edelstahl als Substrat zur Abscheidung von bi-axial orientierten, oxidkeramischen Schichten, insbesondere von Hochtemperatur-Supraleitern der Summenformel $RBa_2Cu_3O_7$ (R= Yttrium oder ein Element der Seltenen Erden) dienen kann und damit sehr gute Eigenschaften erzielt werden können.

In einem Beispiel weist der Edelstahl darüber hinaus einen Nickelanteil von mehr als 9 und weniger als 16 Massenprozent auf. Nach einem anderen Beispiel weist der Edelstahl einen Silicium-Anteil von weniger als 1,5 Massenprozent, bevorzugt von weniger als 1 Massenprozent, auf. Gemäß einem weiteren Beispiel weist der Edelstahl einen Molybdän-Anteil von weniger als 3 Massenprozent auf. Die vorstehenden Anteile wurden in umfangreichen und aufwändigen Experimenten von der Anmelderin bestimmt und haben einerseits den Vorteil, die Kosten für das Substrat gering zu halten und andererseits den Vorteil, eine aufgrund Ihrer mechanischen Eigenschaften bei den prozessbedingten hohen Abscheidetemperaturen Hochtemperatur - Supraleiterschichten mit hohen Stromdichten zu ermöglichen.

In einem Beispiel weist der Edelstahl eine Legierung auf, welche die Bezeichnung 1.4404 nach der europäischen Norm EN10027. Dies entspricht nach der US Norm AISI (American Iron and Steel Institute) einer Legierung mit der Bezeichnung 316L. Die Verwendung eines Stahls aus der bezeichneten Kategorie - und im Rahmen der vorstehenden Einschränkungen bei den Massenanteilen der einzelnen Komponenten - ist ein Edelstahl, der in den üblicherweise erforderlichen Dimensionen auf dem Markt verfügbar ist. Die Verwendung eines solchen Edelstahls aus Ausgangsmaterial für ein Substrat ermöglicht eine kosteneffiziente Herstellung eines entsprechenden Hochtemperatur-Supraleiters.

In einem Beispiel kann der HTS-Bandleiter als ein Band ausgebildet werden, das in einem Beispiel ein Aspektverhältnis von Dicke:Breite < 1:10 aufweist. Weitere beispielhafte Dimensionen für einen HTS-Bandleiter und damit auch für das Edelstahl-Substrat sind wie folgt: Länge von mehr als 10 m, Breite von 12 mm, Dicke von 50 bis 150 μm. Eine Länge von 10 m ist nur beispielhaft, es sind auch andere Längen (z.B. 100 m oder 1000 m denkbar). Die Dicke des Bandes kann zum Beispiel durch Kaltwalzen, das gegebenenfalls eine Vielzahl von Walzschritten umfasst, erreicht werden. Durch die Bereitstellung eines derartigen HTS-Bandleiters ist es möglich, Strom verlustfrei über sehr große Distanzen zu transportieren. Selbstverständlich handelt es sich bei den vorstehenden Dimensionsangaben lediglich um Beispiele. Ein erfindungsgemäßer HTS-Bandleiter kann auch andere Dimensionen (kürzer, länger, breiter, schmaler, dicker oder dünner) als beschrieben aufweisen. Darüber hinaus kann das erfindungsgemäße Substrat auch für Hochtemperatur-Supraleiter mit anderen Dimensionen (z.B. nicht bandförmig, sondern mit einer anderen Form oder Größe) Anwendung finden.

In einem Beispiel ist der HTS-Bandleiter so ausgebildet, dass das Substrat bei Raumtemperatur eine Dehngrenze $R_{P0,2}$ größer als 300 MPa, bevorzugt von größer als 500 MPa (jeweils bei Raumtemperatur) aufweist. In einem Beispiel wird das Substrat kaltgewalzt, um die genannten Dehngrenzen zu erreichen.

Gemäß einem weiteren Beispiel weist das Substrat des HTS-Bandleiters ein plastisches Fließen von weniger als 2 x 10⁻⁵ Prozent/s, bevorzugt von weniger als 1,5 x 10⁻⁵ Prozent/s und besonders bevorzugt von weniger als 1 x 10⁻⁵ Prozent/s bei 700°C und 25 MPa Zugspannung auf. Das Fließverhalten (ein Maß für die Erweichung des Materials) des beanspruchten Edelstahls bei hohen Temperaturen ist besonders vorteilhaft für die Verarbeitung und Herstellung eines HTS-Bandleiters. Der Grund hierfür ist, dass die Beschichtung bei hohen Temperaturen erfolgt und eine Erweichung des Materials zu plastischer Verformung und Rissbildung in der Beschichtung führen könnte, welche die Eigenschaften des so hergestellten Hochtemperatur-Supraleiters drastisch verschlechtern würden. Zur Ermittlung dieses Kennwertes wird eine gängige Zugversuchsanlage zur Aufnahme von Spannungs-Dehnung-Kurven verwendet, bei der die Probe auf einer Länge von ca. 100 mm von einem Ofen umgeben ist. Dabei wird die Probe in die Apparatur eingespannt und mit einer Vorspannung von ca. 4-5 MPa gehalten. Die Probe wird anschließend auf ca. 700 °C aufgeheizt, wobei die Aufheizrate so angepasst ist, dass ein Übersteuern über 700 °C verhindert wird. Das Aufheizen ist üblicherweise nach ca. 10 - 15 Min abgeschlossen. Ist die Temperatur erreicht, wird auf die eigentliche Messspannung von 25 MPa erhöht und diese Spannung (die Spannung ist der Quotient aus Kraft und Querschnittsfläche; die Kraftmessung erfolgt über Kraftmessdosen) konstant gehalten. Gemessen wird dann die Längenänderung ab Messbeginn bezogen auf die Messdauer.

In einem weiteren Beispiel ist der $\mu_r$-Wert des Substrats des HTS-Bandleiters kleiner als 2, gemessen bei einem Außenfeld $H$ von max. 2 x 10⁴ A/m, einer Frequenz $f$ von 70 - 150 Hz und einer Temperatur von 77 K. Die amagnetischen Eigenschaften des Substrats sind wichtig bei der Herstellung eines HTS-Bandleiters. Die Kenngrößen werden in einem standardmäßigen Verfahren ermittelt. Der zu prüfende Bandleiter wird dafür zu einem Zylinder aufgewickelt und mit zwei Spulen (Erreger- und Empfängerspule) torusartig umwickelt. Ein Strom, der in der Erregerspule fließt, erzeugt dabei nach dem Induktionsgesetz (rechte-Hand-Regel) ein magnetisches Feld. Dieses Feld wirkt als magnetisches Außenfeld $H$ auf die Probe (Substratband) ein. Mittels der Empfängerspule wird die magnetischen Antwort des Substrates (magnetische Flussdichte $B$) gemessen. Über den Zusammenhang

$$\mu_r = B \,/\, (H \cdot \mu_0)$$

kann die magnetische Permeabilität des Substrates ermittelt werden ($\mu_0$ := magnetische Permeabilität im Vakuum; $B$ := magnetische Flussdichte; $H$ := magnetische Feldstärke (Außenfeld)).

Erfindungsgemäß weist das Substrat nach einer elektrochemischen Politur eine Winkelabweichungsverteilung von weniger als 10° und eine Winkeländerungsverteilung weniger als 13,5°/μm auf. In einem weiteren Beispiel weist das Substrat eine Winkelabweichungsverteilung von weniger als 7° und eine Winkeländerungsverteilung weniger als 8°/μm auf. In einem anderen Beispiel weist das Substrat eine Winkelabweichungsverteilung von weniger als 4° und eine Winkeländerungsverteilung weniger als 5°/μm auf.
Die Ermittlung der Winkelabweichungsverteilung und der Winkeländerungsverteilung wird nachstehend erläutert. Zunächst werden mit gängigen Verfahren wie Laser-Scanning Mikroskopie, Profilometrie oder dem AFM (atomic force microscope) Höhenprofile in Bandrichtung aufgenommen. Die räumliche Auflösung der Methode sollte dabei besser als 0,5μm, bevorzugt besser als 0,3μm, von Messpunkt zu Messpunkt sein. Von diesen Höhenprofilen der Längsschnitte werden dann die erste und zweite Ableitung ermittelt. Die erste Ableitung korrespondiert dann über die Beziehung

$$\arctan(\alpha) = \partial z/\partial x$$

mit dem Oberflächenwinkel a. Dabei entspricht $\alpha$ dem Winkel zwischen gemittelter Substratoberfläche und dem aktuellen Punkt $x$ des Profils und $\partial z/\partial x$ beschreibt die erste Ableitung am Punkt $x$ des Profils.

Die zweite Ableitung kann als Winkeländerung in der Einheit °/μm betrachtet werden. Bildet man aus den Winkelabweichungen Histogramme, erhält man eine Auftragung der Winkelabweichungsverteilung. Ausgedrückt mittels Gaußverteilung können aus deren Halbwertsbreiten die charakteristische Größe der Winkelabweichungsverteilung in Grad ° ermittelt werden. Die Halbwertsbreiten ermittelt aus dem Histogramm der zweiten Ableitung (Winkeländerung) werden als Winkeländerungsverteilung bezeichnet und geben den charakteristischen Wert der Winkeländerungsverteilung in °/μm an.

In einem Beispiel wird die Oberfläche des Substrats des HTS-Bandleiters einer elektrochemischen Politur in einem Schwefelsäure-Phosphorsäure-Elektrolyten bei 20-60 °C und Stromdichten von 40 - 70 A/dm² für 12 - 36 s unterzogen. Ein anderes Beispiel für eine elektrochemische Politur der Oberfläche des Substrats ist ein Schwefelsäure-Phosphorsäure-Elektrolyt bei 30-50 °C und Stromdichten von 50 - 60 A/dm² für 15 - 25 s, wobei der Elektrolyt 50-70% Phosphorsäure und 25-40% Schwefelsäure umfasst. In einem weiteren Beispiel kann die elektrochemische Politur in einem Schwefelsäure-Phosphorsäure-Elektrolyten erfolgen, wobei der Elektrolyt 50-70% Phosphorsäure, 25-40% Schwefelsäure, 1-10% Dieisentrisulfat ($Fe_2(SO_4)_3$), 1-5% Zitronensäure und 0,25 bis 0,5% Nickelsulfat umfasst. Die vorstehend erläuterten Elektrolyte haben sich als besonders geeignet erwiesen, da diese Elektrolyten nicht zunächst mit Metallionen angereichert werden müssen (aus denen sich dann Metallsäuren bilden), bevor eine Polierwirkung einsetzt. Andere Elektrolyte haben diesen Nachteil, wobei dann zunächst das Band zunächst etwas poliert werden muss, um die Metallionen freizusetzen.

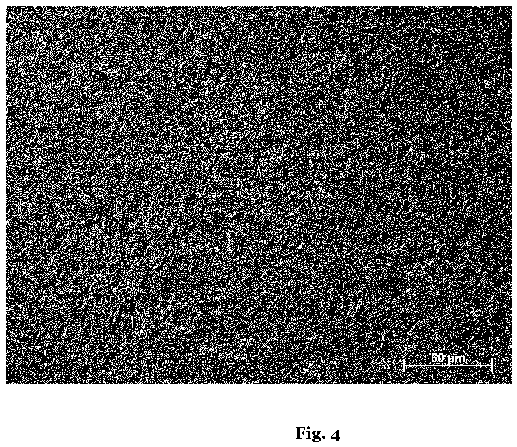

Die Anmelderin hat herausgefunden, dass eine zu kurze elektrochemische Politur dabei genauso nachteilig ist, wie eine zu lange andauernde, da es hierbei zu einer Gefügepräparation und somit zur Freilegung der Korngrenzen, Gleitbänder und Zwillingsgrenzen kommen kann. Diese sind, wie Abbildung 4 zeigt in einer hohen Dichte vorhanden. Da im elektrochemischen Bereich oberhalb des Durchschlagpotentials poliert wird und der erzeugte Abtrag ausreichend hoch sein muss, dürfen die Stromdichten nicht zu niedrig gewählt werden. Zu hohe Stromdichten wiederum heizen das Band zu stark auf.

Die Qualitätskontrolle der polierten Bänder erfolgt dann bevorzugt über Analysen mittels eines konfokalen Weißlichtinterferometers in der Art und Weise, dass die Primäraufnahmen mittels eines $4\mu m$-Gauß-Filters bearbeitet und dargestellt werden. Oberflächenunebenheiten, auf die die aufwachsende MgO-ISD - Schicht sensitiv reagiert, werden so besonders hervorgehoben. Alternative Messmethoden verwenden ein AFM oder ein Profilometer. In beiden Fällen wird eine feine Spitze über die Oberfläche geführt und die Änderung der z-Komponente (Höhe) gemessen. Die Aufnahme der Messwerte erfolgt üblicherweise induktiv, kapazitiv oder über einen Lichtzeiger und eine Differenzdiode.

Für alle hierin genannten Substrate gilt, dass die eingangs erwähnten Legierungen verwendet werden können. Dies trifft insbesondere für die Substrate zu, die einer elektrochemischen Politur unterzogen werden, wie vorstehend erläutert.

### 4. Kurze Beschreibung der Figuren

Beispielhafte Ausgestaltungen der vorliegenden Erfindung werden in der folgenden detaillierten Figurenbeschreibung unter Bezug auf die Figuren erläutert, wobei:

Fig. 1: den Aufbau eines HTS-Bandleiters in Übereinstimmung mit der vorliegenden Erfindung zeigt;

Fig. 2-3: den Einfluss der elektrochemischen Politur auf das Substrat darstellen;

Fig. 4: eine lichtmikroskopische Aufnahme einer Edelstahlprobe mit einem präparierten Gefüge darstellt;

Fig. 5-7: Oberflächen von Substraten nach der Politur zeigen, wobei die Aufnahmen mittels eines konfokalen Weißlichtinterferometers erstellt wurden; und

Fig. 8: ein Beispiel für eine Winkelabweichungsverteilung in einem Histogramm darstellt.

### 5. Detaillierte Beschreibung der Figuren

Fig. 1 zeigt den beispielhaften Aufbau eines HTS-Bandleiters 100. Dieser umfasst ein Substrat 110 welches erfindungsgemäß Edelstahl umfasst. Wie vorstehend erläutert worden ist, weist der Edelstahl einen Chrom-Anteil von weniger als 18 Massenprozent auf. In einem weiteren Beispiel beträgt der Nickelanteil mehr als 9 Massenprozent, aber weniger als 16 Massenprozent. Einen vorteilhaften Einfluss auf die Anschaffungskosten und die Stromdichte eines Hochtemperatur-Supraleiters hat ebenfalls der geringe Silicium-Anteil von weniger als 1,5 Massenprozent (oder weniger als 1 Massenprozent). Weitere beispielhafte Bestandteile eines erfindungsgemäßen Substrats 110 sind in der folgenden Tabelle zusammengefasst:

Tabelle 1: Beispielhafte Bestandteile für ein erfindungsgemäßes Substrat

| Element | Massen prozent |
|---------|----------------|
| Cr | 14,0 - 18,0 |
| Ni | 9,0 - 16,0 |
| Mo | < 3,0 |
| Mn | < 2,0 |
| Si | < 1,5 |
| C | < 0,05 |
| N | < 0,2 |
| P | < 0,05 |
| S | < 0,03 |

Das Element Eisen (Fe) wird nicht explizit mit aufgeführt und bildet jeweils den restlichen Anteil an der Gesamtzusammensetzung des Edelstahls.

Ferner umfasst der HTS-Bandleiter 100 eine biaxial texturierte Pufferschicht 120. Ein beispielhaftes Verfahren zur Aufbringung der Pufferschicht ist die "ion beam assisted deposition" (IBAD), bei der während der Deposition ein unterstützender Ionenstrahl unter einem bestimmten Winkel auf die Substratoberfläche gerichtet wird. Bei einem anderen beispielhaften Verfahren, der "inclined substrate deposition" (ISD) erfolgt die Beschichtung aus der Gasphase unter einem Winkel auf ein gekipptes Substrat. Bei hohen Beschichtungsraten und geeigneter Wahl der Depositionsparameter lassen sich auch dadurch orientierte Schichten abscheiden. Auf die Pufferschicht 120 wird der Hochtemperatur-Supraleiter 130 aufgebracht. Als Hochtemperatur-Supraleiter kommen beispielhaft Verbindungen mit der Summenformel $RBa_2Cu_3O_7$ (R= Yttrium oder ein Element der Seltenen Erden) zum Einsatz. Die Dicke einer Hochtemperatur-Suprleiterschicht kann zum Beispiel 500 nm oder mehr betragen. Zuletzt wird auf die Hochtemperatur-Supraleiterschicht eine Kontaktschicht 140 aufgebracht. Dabei kommt beispielsweise ein Edelstahl wie Silber zum Einsatz, das mit einer Dicke von mindestens 100 nm, bevorzugt von mindestens 500 nm, aufgetragen wird.

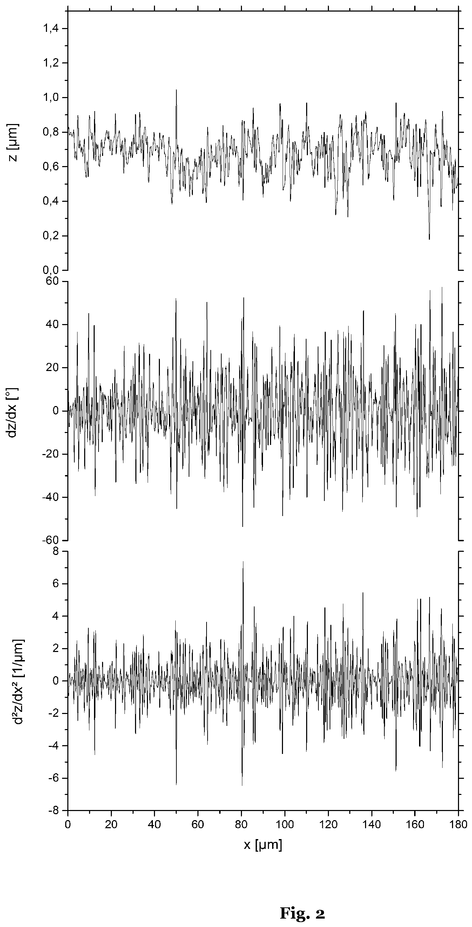

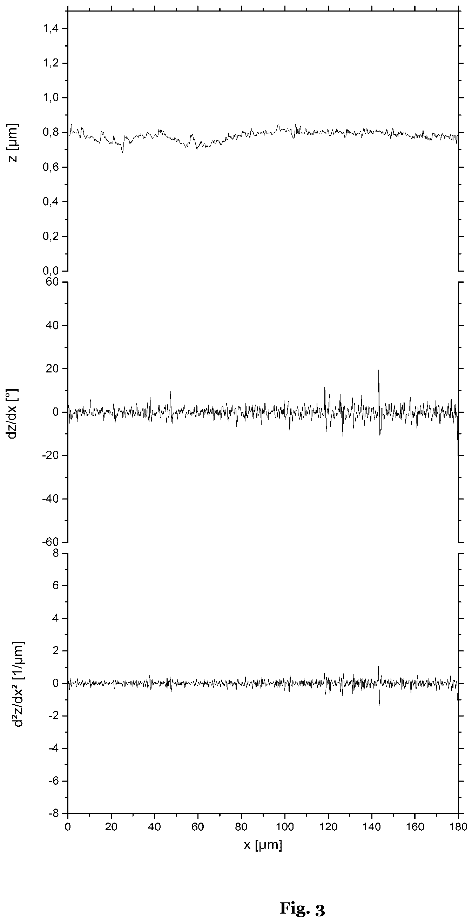

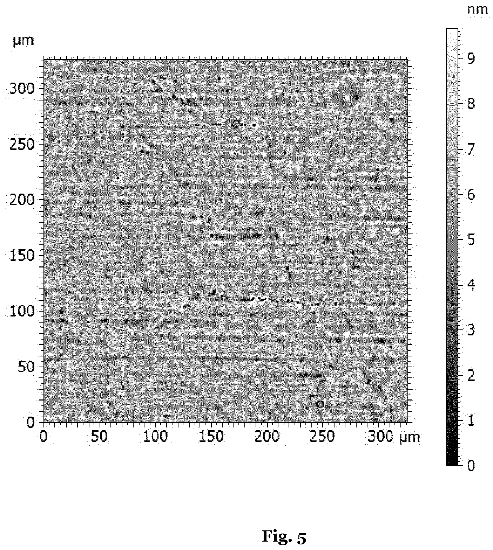

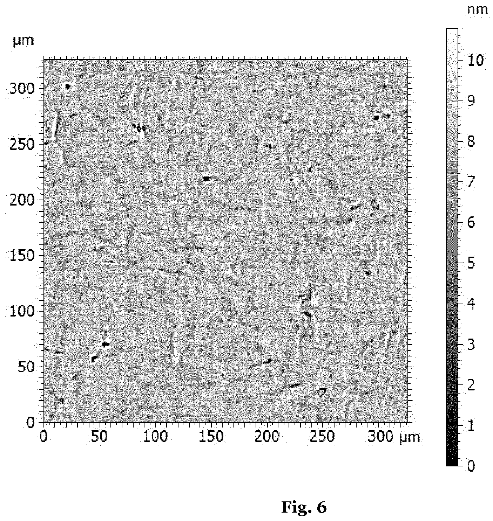

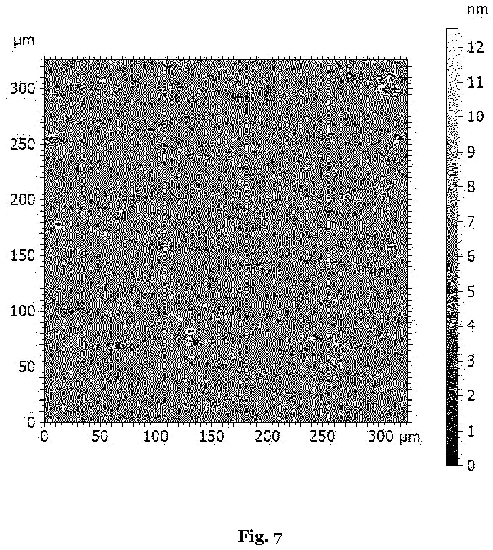

Die Figuren 2 und 3 stellen den Einfluss der elektrochemischen Politur auf das Substrat dar. Dabei betrifft Fig. 2 ein Edelstahlsubstrat vor der Politur und Fig. 3 zeigt dasselbe Edelstahlsubstrat nach der Politur. Das Politurverfahren wurde vorstehend bereits erläutert. Die obere Zeile zeigt die vertikale Variation z der Oberfläche in Mikrometern ($\mu$m) in Abhängigkeit von der Position x auf der Oberfläche des Edelstahlsubstrats (ebenfalls in $\mu$m). In der mittleren Zeile ist die erste Ableitung, d.h. der Oberflächenwinkel $\alpha$ gezeigt (Winkelabweichung). In der unteren Zeile ist die zweite Ableitung, d.h. Winkeländerung in der Einheit °/$\mu$m gezeigt. Ein Vergleich der beiden Figuren 2 und 3 zeigt, dass die jeweiligen Parameter bei einem polierten Edelstahlsubstrat erheblich weniger schwanken und vor allem generell niedrigere Werte aufweisen. Dabei gibt die erste Ableitung unter anderem Auskunft darüber, wie schnell sich die Oberfläche des Substrats verändert. Die zweite Ableitung gibt unter anderem Auskunft über die Krümmung der Oberfläche des Edelstahlsubstrats. Große Winkelabweichungen und große Winkeländerungen der Substratoberfläche würden sich bis in die HTS-Schicht abbilden und hier zu einer Reduzierung der kritischen Stromdichte führen. Der Grund hierfür sind die durch das epitaktische Wachstum der HTS-Schicht übernommenen Kornstrukturen. Oberflächenwelligkeiten oder Kanten und Grate auf der Substratoberfläche, dargestellt durch die Winkelabweichungen und Winkeländerungen, sind der Hauptgrund für die Erhöhung der Korngrenzwinkel der HTS-Schicht und somit für die Erniedrigung der kritischen Stromdichte. Die Figuren 2 (vor der elektrochemischen Politur) und 3 (nach der elektrochemischen Politur) stellen das Profil der Metallsubstratoberfläche inkl. der ersten und zweiten Ableitungen dar, die mittels Laser Scanning Microscope bei 500-facher Vergrößerung gemessen wurde. Figur 4 stellt eine lichtmikroskopische Aufnahme einer Edelstahlprobe dar, bei welcher das Gefüge präpariert wurde. Die hier angewandte Prozedur der Gefügepräparation sah eine mechanische Politur bis zu einer Polierpaste mit einer Partikelgröße von max. 1 $\mu$m vor. Anschließend wurde das Gefüge mittels Glimmentladungsplasma präpariert. Das Verfahren ist in DOI 10.3139/147.110376 offenbart. Insbesondere ist das typische kaltgewalzte Gefüge eines austenitischen Edelstahls zu erkennen. Bei dem für die Figur 4 verwendeten Stahl handelt es sich um einen Edelstahl mit der Bezeichnung 1.4404. Die Fig. 5 bis 7 zeigen Darstellungen verschiedener erhaltener Oberflächen, die mittels eines konfokalen Weißlichtinterferometers aufgenommen wurden. Dabei wurde eine Primäraufnahme mittels eines 4 $\mu$m-Gauß-Filters bearbeitet und dargestellt. Diese Art der Darstellung hat den Vorteil, dass Oberflächenunebenheiten, auf die die aufwachsende MgO-ISD - Schicht sensitiv reagiert, so besonders hervorgehoben werden. Die Fig. 5 zeigt weitestgehend lineare Strukturen von links nach rechts (Bandrichtung), welche für eine anschließende Beschichtung nicht hinderlich sind. Analysen haben gezeigt, dass Defekte mit Ausdehnung in Bandrichtung einen weitaus geringeren Einfluss auf die kritische Stromdichte haben, als Strukturen mit einer Ausdehnung quer zur Bandrichtung. Die Fig. 6 zeigt Strukturen, bei denen es sich um nicht gänzlich entfernte Walzstrukturen handelt, welche ein orientiertes Wachstum der MgO ISD - Schicht und der HTS-Schicht behindern und somit eine Erniedrigung der kritischen Stromdichten erzeugen. Die Strukturen haben dabei eine sehr starke Ausdehnung quer zur Bandrichtung (auf der Aufnahme von unten nach oben). Die Fig. 7 zeigt Strukturen, welche durch eine zu lange elektrochemische Politur (Gefügedarstellung) erzeugt werden und ein orientiertes Wachstum der MgO ISD - Schicht und der HTS-Schicht behindern und somit eine Erniedrigung der kritischen Stromdichten erzeugen. Zu erkennen sind Gleitbänder (Ausdehnung eher quer zur Bandrichtung (von unten nach oben)).

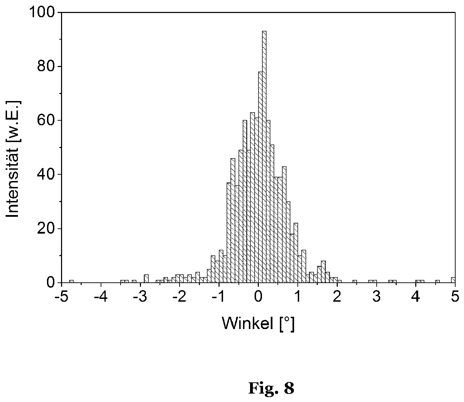

In Fig. 8 ist ein Histogramm dargestellt, welches aus den Winkelabweichungen für ein Längsprofil eines erfindungsgemäßen Edelstahlsubstrats gewonnen wurde. Man erhält somit eine Auftragung der Winkelabweichungsverteilung. Die Halbwertsbreiten der Verteilung der zweiten Ableitung werden als Winkeländerungsverteilung bezeichnet. Diese können mittels Halbwertsbreiten einer Gaußverteilung ausgedrückt werden. Die Halbwertsbreiten liefern dann eine charakteristische Größe der Oberflächenmorphologie ausgedrückt in Grad ° (wie hier im dargestellten Beispiel) oder in °/$\mu$m (im Falle eines Histogramms der Winkeländerungen).

## Patentansprüche

1. Hochtemperatur-Supraleiter-Bandleiter, HTS-Bandleiter, aufweisend ein Substrat aus einem austenitischen Edelstahl mit einem Chrom-Anteil von weniger als 18 Massenprozent, **dadurch gekennzeichnet, dass** das Substrat nach einer elektrochemischen Politur eine Winkelabweichungsverteilung eines Oberflächenwinkels $\alpha$ mit einer Halbwertsbreite von weniger als 10° und eine Winkeländerungsverteilung mit einer Halbwertsbreite von weniger als 13,5°/$\mu$m aufweist, wobei der Oberflächenwinkel $\alpha$ über $\arctan(\alpha) = \partial z/\partial x$ mit dem Höhenprofil z(x) des Bandleiters in Bandrichtung x korrespondiert.

2. HTS-Bandleiter nach Anspruch 1, wobei das Substrat eine Winkelabweichungsverteilung von weniger als 7° und eine Winkeländerungsverteilung weniger als 8°/$\mu$m aufweist.

3. HTS-Bandleiter nach Anspruch 2, wobei das Substrat eine Winkelabweichungsverteilung von weniger als 4° und eine Winkeländerungsverteilung weniger als 5°/$\mu$m aufweist.

**4.** HTS-Bandleiter nach einem der Ansprüche 1 bis 3, wobei die Oberfläche des Substrats einer elektrochemischen Politur in einem Schwefelsäure-Phosphorsäure-Elektrolyten bei 20-60 °C und Stromdichten von 40 - 70 A/dm$^2$ für 12 - 36 s unterzogen wurde.

**5.** HTS-Bandleiter nach einem der Ansprüche 1 bis 3, wobei die Oberfläche des Substrats einer elektrochemischen Politur in einem Schwefelsäure-Phosphorsäure-Elektrolyten bei 30-50 °C und Stromdichten von 50 - 60 A/dm$^2$ für 15 - 25 s unterzogen wurde, wobei der Elektrolyt 50-70% Phosphorsäure und 25-40% Schwefelsäure umfasst.

**6.** HTS-Bandleiter nach einem der Ansprüche 1-3, wobei die Oberfläche des Substrats einer elektrochemischen Politur in einem Schwefelsäure-Phosphorsäure-Elektrolyten unterzogen wurde, wobei der Elektrolyt 50-70% Phosphorsäure, 25-40% Schwefelsäure, 1-10% Dieisentrisulfat, 1-5% Zitronensäure und 0,25 bis 0,5% Nickelsulfat umfasst.

## Claims

**1.** High temperature superconducting tape conductor, HTS tape conductor, comprising a substrate of an austenitic stainless steel having a chromium content of less than 18 mass percent, **characterized in**, the substrate, after electrochemical polishing, having an angular deviation distribution of a surface angle $\alpha$ with a half-width of less than 10° and an angular change distribution with a half-width of less than 13.5°/$\mu$m, wherein the surface angle $\alpha$ corresponds via arctan($\alpha$) = $\partial z/\partial x$ to the height profile z(x) of the tape conductor in tape direction x.

**2.** HTS tape conductor according to claim 1, wherein the substrate has an angular deviation distribution of less than 7° and an angular change distribution of less than 8°/$\mu$m.

**3.** HTS tape conductor of claim 2, wherein the substrate has an angular deviation distribution of less than 4° and an angular change distribution of less than 5°/$\mu$m.

**4.** HTS tape conductor according to any one of cairns 1 - 3, wherein the surface of the substrate has been subjected to electrochemical polishing in a sulfuric acid-phosphoric acid electrolyte at 20 - 60°C and current densities of 40 - 70 A/dm$^2$ for 12 - 36 s.

**5.** HTS tape conductor according to any one of claims 1 to 3, wherein the surface of the substrate has been subjected to electrochemical polishing in a sulfuric acid-phosphoric acid electrolyte at 30 - 50°C and current densities of 50 - 60 A/dm$^2$ for 15-25 s, said electrolyte comprising 50 - 70% phosphoric acid and 25 - 40% sulfuric acid.

**6.** HTS tape conductor according to any one of claims 1 to 3, wherein the surface of the substrate has been subjected to electrochemical polishing in a sulfuric acid-phosphoric acid electrolyte, said electrolyte comprising 50 - 70% phosphoric acid, 25 - 40% sulfuric acid, 1 - 10% iron (III) sulfate, 1 - 5 % citric acid and 0.25 to 0.5% nickel sulfate.

## Revendications

**1.** Ruban conducteur supraconducteur à haute température, ruban conducteur HTS, présentant un substrat en un acier inoxydable austénitique ayant une teneur en chrome inférieure à 18 pourcents en masse, **caractérisé en ce que** le substrat présente, après un polissage électrochimique, une distribution des écarts angulaires d'angle de surface $\alpha$ avec une largeur à mi-hauteur inférieure à 10° et une distribution des variations angulaires avec une largeur à mi-hauteur inférieure à 13,50/$\mu$m, l'angle de surface $\alpha$ correspondant, avec arctan($\alpha$) = $\partial z/\partial x$, au profil en hauteur z(x) du ruban conducteur dans la direction x du ruban.

**2.** Ruban conducteur HTS selon la revendication 1, dans lequel le substrat présente une distribution des écarts angulaires inférieure à 7° et une distribution des variations angulaires inférieure à 8°/$\mu$m.

**3.** Ruban conducteur HTS selon la revendication 2, dans lequel le substrat présente une distribution des écarts angulaires inférieure à 4° et une distribution des variations angulaires inférieure à 5°/$\mu$m.

**4.** Ruban conducteur HTS selon l'une des revendications 1 à 3, dans lequel la surface du substrat a été soumise à un polissage électrochimique dans un électrolyte à l'acide sulfurique-acide phosphorique à 20 à 60 °C, pour des densités de courant de 40 à 70 A/dm$^2$ pendant 12 à 36 s.

**5.** Ruban conducteur HTS selon l'une des revendications 1 à 3, dans lequel la surface du substrat a été soumise à un polissage électrochimique dans un électrolyte à l'acide sulfurique-acide phosphorique à 30 à 50 °C, pour des densités de courant de 50 à 60 A/dm$^2$ pendant 15 à 25 s, l'électrolyte comprenant 50 à 70 % d'acide phosphorique et 25 à 40 % d'acide sulfurique.

**6.** Ruban conducteur HTS selon l'une des revendications 1 à 3, dans lequel la surface du substrat a été soumise à un polissage électrochimique dans un électrolyte à l'acide sulfurique-acide phosphorique, l'électrolyte comprenant 50 à 70 % d'acide phosphorique, 25 à 40 % d'acide sulfurique, 1 à 10 % de trisulfate de fer, 1 à 5 % d'acide citrique et 0,25 à 0,5 % de sulfate de nickel.

100

140

130

120

110

Fig. 1

**Fig. 2**

**Fig. 3**

**Fig. 4**

**Fig. 5**

Fig. 6

**Fig. 7**

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0872579 A
- EP 1178129 A
- EP 0669411 A
- EP 0909340 A
- EP 1143532 A
- JP 2011113662 A
- US 2012021917 A1
- EP 0441724 A2
- EP 1143532 A1
- EP 2506324 A2